(19) **Europäisches Patentamt / European Patent Office / Office européen des brevets**

(11) **EP 1 319 956 B1**

(12) **FASCICULE DE BREVET EUROPEEN**

(45) Date de publication et mention
de la délivrance du brevet:
**20.05.2009 Bulletin 2009/21**

(51) Int Cl.:
***G01R 31/36*** (2006.01)

(21) Numéro de dépôt: **02292749.5**

(22) Date de dépôt: **04.11.2002**

(54) **Système de détermination de l'état de charge et de la tension d'une batterie de stockage d'énergie électrique, notamment pour véhicule automobile**

System für die Festlegung des Ladezustandes und der Spannung einer elektrischen Speicherbatterie, insbesondere für ein Kraftfahrzeug

System for determining state of charge and voltage of an electrical storage battery, especially for a motor vehicle

(84) Etats contractants désignés:
**AT BE BG CH CY CZ DE DK EE ES FI FR GB GR IE IT LI LU MC NL PT SE SK TR**

(30) Priorité: **14.12.2001 FR 0116259**

(43) Date de publication de la demande:
**18.06.2003 Bulletin 2003/25**

(73) Titulaire: **Peugeot Citroën Automobiles SA 92200 Neuilly sur Seine (FR)**

(72) Inventeurs:
• **Bianchi, Valérie
92400 Courbevoie (FR)**
• **Chabot-Petrault, Christine
92700 Colombes (FR)**
• **Dugast, Alain
75013 Paris (FR)**
• **Ovazza, Thierry
91430 Igny (FR)**

(74) Mandataire: **Ménès, Catherine et al
Peugeot Citroën Automobiles SA
DRIA/PPIQ/BLE
18, rue des Fauvelles
92250 La Garenne Colombes (FR)**

(56) Documents cités:
**EP-A- 0 714 033          EP-A- 1 081 499
US-A- 5 936 383          US-B1- 6 285 163**

## Description

La présente invention concerne un système de détermination de l'état de charge et de la tension d'une batterie de stockage d'énergie électrique, notamment pour véhicule automobile.

En particulier, l'invention est applicable pour des batteries de type plomb/acide 12V ou 36V.

Un grand nombre de paramètres influent sur le fonctionnement d'une batterie de ce type, certains de ces paramètres étant maîtrisables, d'autres non.

Pour différentes raisons, il peut être intéressant de déterminer l'état de charge et la tension d'une telle batterie.

Dans l'état de la technique, ceci est réalisé en cumulant les courants de décharge et de charge de la batterie dans le temps, mais l'on conçoit que de tels procédés présentent un certain nombre de limitations et d'imprécisions.

Le document US 6,285,163 décrit un système conforme au préambule de la revendication 1 et qui présente également ce type de problèmes.

Le but de l'invention est donc de résoudre ces problèmes.

A cet effet, l'invention a pour objet un système de détermination de l'état de charge et de la tension d'une batterie de stockage d'énergie électrique, notamment pour véhicule automobile, selon la revendication 1.

L'invention sera mieux comprise à la lecture de la description qui va suivre, donnée uniquement à titre d'exemple et faite en se référant aux dessins annexés, sur lesquels

- la Fig.1 illustre de façon schématique un système de détermination selon l'invention ;
- la Fig. 2 représente un schéma synoptique de premiers moyens de calcul d'un état de charge entrant dans la constitution d'un tel système ;
- la Fig 3 représente un schéma synoptique de seconds moyens de calcul de la tension entrant dans la constitution d'un tel système ; et
- les Figs 4 à 13 illustrent différentes courbes montrant les résultats obtenus.

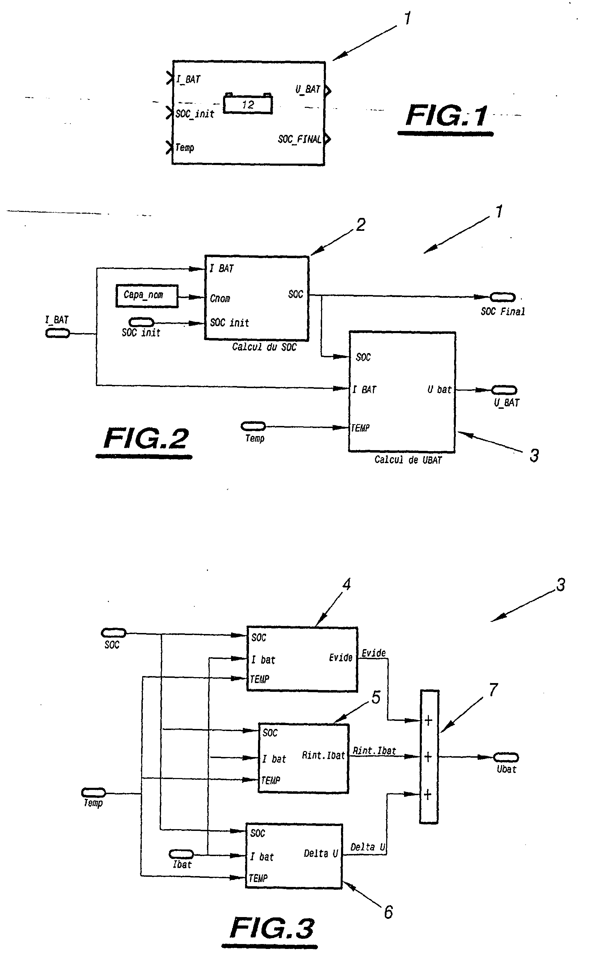

On a en effet illustré sur la figure 1, de façon schématique, un système de détermination de l'état de charge et de la tension d'une batterie de stockage d'énergie électrique, notamment pour véhicule automobile, qui doit être replacé dans le contexte du réseau électrique de bord de ce véhicule.

Ce système est désigné par la référence générale 1 sur cette figure et reçoit en entrée une information de courant batterie I_BAT, une information d'état de charge initial de la batterie SOC_Init, et une information de température de la batterie TEMP et délivre en sortie une information de la tension de batterie U_BAT et une information d'état de charge final SOC_FINAL.

Ce système doit donc être capable d'évaluer la tension aux bornes de la batterie sous différentes conditions de température et d'état de charge, mais également d'offrir un comportement réaliste au vu des sollicitations en courant de la batterie.

Il est cependant inutile d'affiner la modélisation du fonctionnement de la batterie au niveau électrochimique pour l'utilisation souhaitée.

A cet effet, le modèle retenu est à la fois physique et comportemental :

- Physique dans le sens où la batterie est modélisée par une équation électrique équivalente constituée de trois termes :

$$U = [E \pm RI \pm DU]$$

avec E qui représente la force électromotrice à vide, R la résistance interne équivalente de la batterie vue par le réseau, I le courant traversant la batterie, avec si I<0 un courant sortant et si I>0 un courant entrant dans celle-ci et DU une fonction non linéaire de détermination d'un écart de tension correctif, pouvant par exemple se présenter sous la forme d'une fonction exponentielle. Ces trois termes dépendent alors de la température, de l'état de charge et du courant de batterie ; et

- Comportemental dans le sens où les variations de la résistance interne sont cartographiées à partir de différents essais disponibles pour chaque type de batteries, correspondant en fait aux données des fournisseurs.

Cependant, la difficulté réside dans le fait d'obtenir un modèle de batterie précis à 50 mV près, valable pour toutes les batteries considérées et en particulier les batteries acide/plomb 12 ou 36V, dans les plages de fonctionnement suivantes :

- Etat de charge variant de 40 à 100% (100% correspondant à une batterie totalement chargée) ;
- Plage de température allant de -30°C jusqu'à 50°C ;
- Plage de courant de charge et/ou de décharge allant de 0 à 200 ampères ; et
- Tension de fonctionnement variant de 6 à 16 V.

Des comparaisons entre les tensions résultant de la détermination et des mesures de la tension de batterie réalisées sur banc permettent de vérifier la précision du système.

On conçoit donc que les données utilisées tout au long de la présente description sont les données batterie, ces données étant des valeurs issues d'essais ou de mesures sur différentes batteries pour différentes conditions de fonctionnement.

Il a donc été possible à partir des connaissances sur les batteries, par exemple au plomb/acide et des données batterie, de développer un système répondant aux objectifs décrits précédemment.

Les données batterie portent sur trois types de fonctionnement, à savoir un fonctionnement en batterie en circuit ouvert, un fonctionnement en batterie en charge et un fonctionnement en batterie en décharge.

Les caractéristiques sont les suivantes :

- les tensions à vide en fonction de l'état de charge et de la température de la batterie ;
- les courants d'acceptance de charge, c'est-à-dire le courant absorbé par la batterie en fonction de la tension de charge, de l'état de charge et de la température de l'électrolyte de la batterie ; et
- les tension de décharge en fonction du courant de décharge imposé, de l'état de charge et de la température de la batterie.

On peut estimer que pour une batterie 12 V, une variation de 5% de l'état de charge de la batterie entraîne un écart de 50 mV sur la valeur de la tension à vide.

En ce qui concerne l'influence de la température, une variation de 10°C entraîne un écart de 8 mV sur la valeur de la tension à vide.

Si l'on veut respecter les causalités du réseau électrique de bord du véhicule. à savoir que l'alternateur est équivalent à une source de courant et la batterie à une source de tension, le modèle de la batterie doit être construit de manière à avoir en sortie la tension de la batterie.

Comme cela a été indiqué précédemment, ce modèle de batterie possède comme entrée le courant de charge ou de décharge ainsi que l'état de charge initial et la température de l'électrolyte de la batterie. Les sorties sont la tension aux bornes de la batterie et le nouvel état de charge.

Le comportement d'une batterie étant différent en charge et en décharge, on procède donc à deux étapes de modélisation.

En effet, le rendement de la batterie est différent en charge et en décharge,

Le rendement est égal à 1 pour la décharge et peut être inférieur à 1 pour la charge en fonction de l'état de charge et de la température.

En décharge, les données batterie correspondantes sont obtenues pour des courants de décharge constants. L'information de courant batterie est une grandeur d'entrée du modèle. Les données batterie peuvent donc être utilisées sans modification.

En décharge, la notion de pseudo-paramètre est introduite. La pseudo-tension à vide correspond à l'intersection entre la tangente à la caractéristique en décharge et l'axe des ordonnées.

La pseudo-résistance interne s'identifie comme étant la pente de la tangente à la caractéristique en décharge pour des courants forts.

Lors d'une première étape, à la tension aux bornes de la batterie, on retire les termes Epseudo et Rpseudo*I, pour obtenir un delta de tension (Epseudo et Rpseudo correspondant aux pseudo-paramètres de la batterie cités ci-dessus).

Pour modéliser le delta de tension restant, une loi mathématique faisant intervenir une forme exponentielle est retenue comme cela a été expliqué précédemment.

Les deux paramètres de cette loi non linéaire sont dépendants de la température, de l'état de charge de la batterie et du courant de décharge imposé à la batterie.

Ainsi, cette relation peut s'établir de la façon suivante :

$$\Delta U = A\,(\theta,\,SOC)\,e^{-B\,(\theta,SOC)\,I\,BAT}$$

En utilisant les données statistiques en décharge, on peut identifier les paramètres du modèle en décharge. Une fois l'équation fixée et les paramètres identifiés, on obtient un modèle de batterie en décharge.

Dans le cas du fonctionnement en charge, la batterie est soumise à une tension constante et l'information de courant d'acceptance de charge est donc une donnée de sortie.

Les données batterie sont réunies sous la forme de tableaux informant, pour une température donnée, le courant d'acceptance de charge (Iacc) en fonction de l'état de charge de la batterie et de la tension de charge imposée (Ubat).

Afin de prendre en considération les problèmes de causalités, il est nécessaire de transformer ces données de façon à obtenir une information de tension en sortie de la batterie.

Lors d'une première étape et contrairement au fonctionnement en décharge, à la tension aux bornes de la batterie, on retire la tension à vide de celle-ci. Cette tension à vide est une caractéristique de la batterie et dépend de l'état de charge de la batterie et de la température de celle-ci.

Les deltas de tension obtenus sont fonction de la température de la batterie, de l'état de charge et du courant d'acceptance de charge de celle-ci.

L'analyse de ces deltas de tension permet d'adapter la loi mathématique utilisée en décharge.

Les deux paramètres du terme non linéaire dépendent de la température, de l'état de charge de la batterie et du courant de charge de la batterie.

Contrairement au modèle en décharge, le terme résistif est identifié en même temps que les deux paramètres du terme non linéaire du modèle.

En utilisant les données statistiques en charge, éventuellement re-transformées, on peut identifier les paramètres du modèle en charge.

Une fois l'équation fixée et les paramètres identifiés, on obtient un modèle de batterie en charge.

Ceci est illustré par exemple sur la figure 2 et la figure 3.

Sur la figure 2, on peut en effet constater que le système de détermination selon l'invention comporte des premiers moyens de calcul d'un état de charge final désignés par la référence générale 2, qui reçoit en entrée des informations d'état de charge initial SOC_Init, de capacité nominale de la batterie CAPA_Nom et de courant dans la batterie I_BAT.

Ceci permet alors à ces moyens de déterminer un état de charge final SOC_FINAL.

Cette information d'état de charge final est introduite dans des seconds moyens de calcul de la tension recevant donc en entrée cette information d'état de charge final, de courant dans la batterie I_BAT et de température TEMP de celle-ci pour déterminer une tension correspondante U_BAT.

Ces moyens sont désignés par la référence générale 3 sur cette figure.

En fait et comme cela est illustré sur la figure 3, ces seconds moyens de calcul 3 comportent des moyens d'estimation de la tension à vide de la batterie, désignés par la référence générale 4, à partir de l'état de charge SOC, du courant dans la batterie I_BAT et de la température TEMP, des moyens de calcul d'une tension correspondant à la résistance interne équivalente de la batterie désignés par la référence générale 5, recevant en entrée les mêmes informations que les moyens d'estimation de la tension à vide et des moyens de calcul à partir d'une fonction non linéaire d'un écart de tension correctif, ces moyens étant désignés par la référence générale 6 et recevant en entrée les mêmes informations que décrites précédemment.

Ces différents moyens 4,5,6 délivrent alors une information de force électromotrice à vide, de la tension correspondant à la résistance interne équivalente de la batterie et d'écart de tension correctif, à des moyens 7 de combinaison de ces trois valeurs pour délivrer la tension de batterie U_BAT.

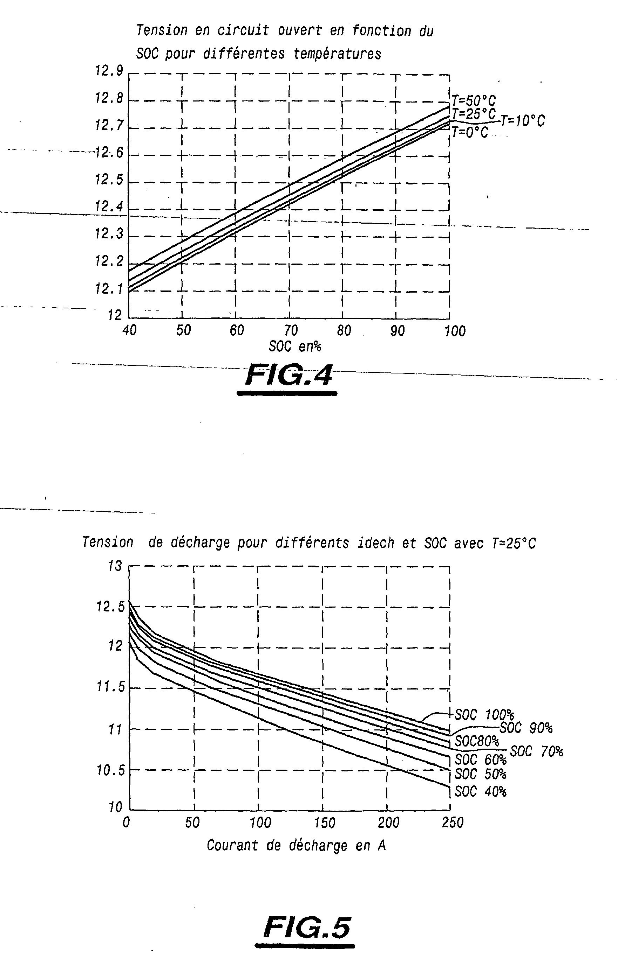

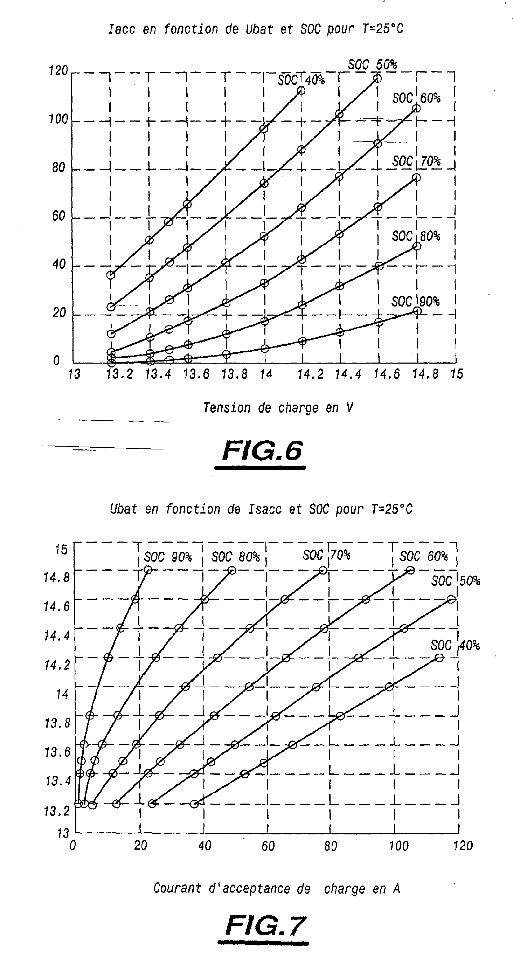

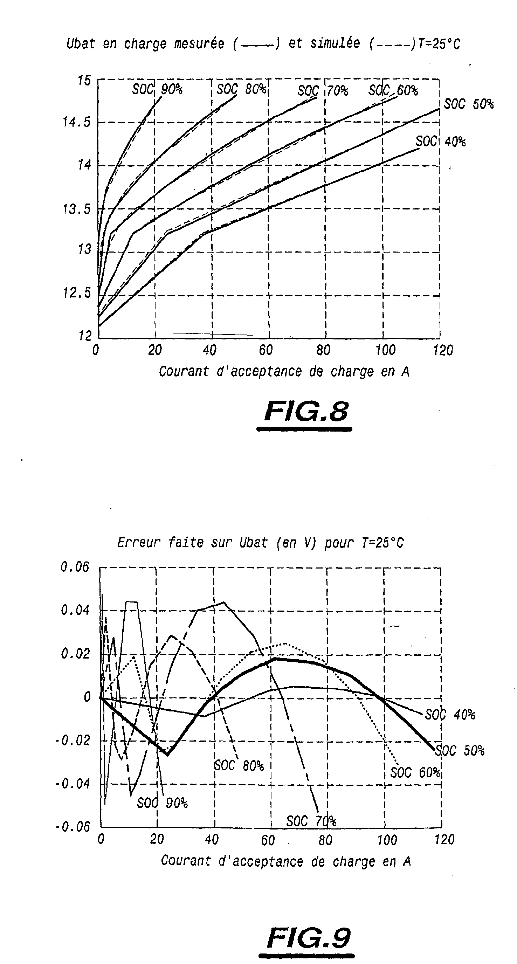

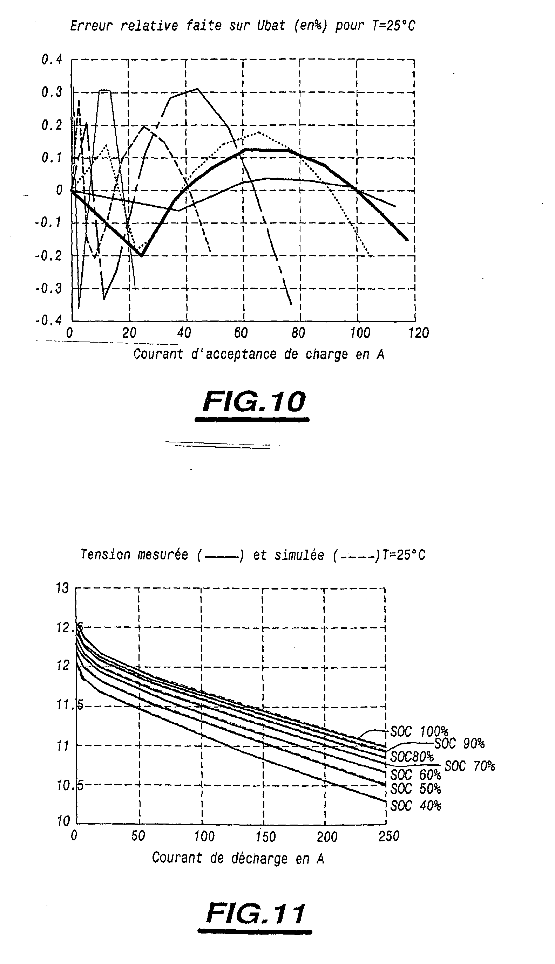

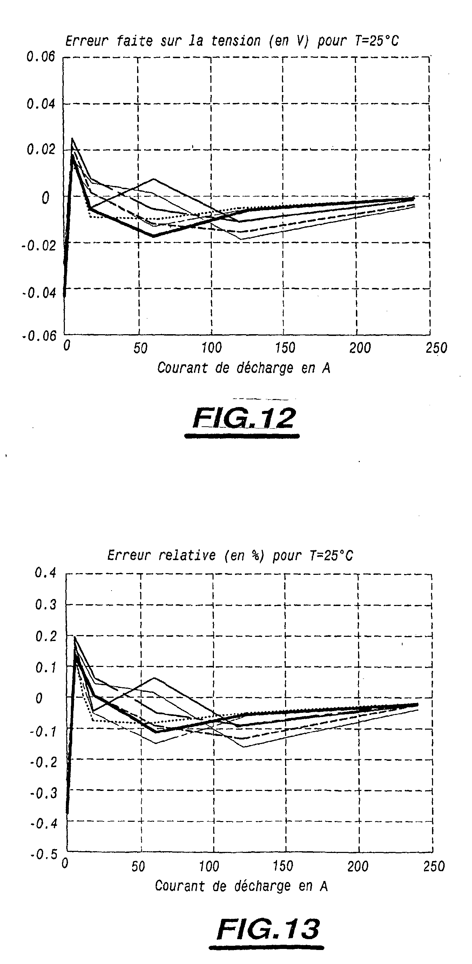

Les figures 4 à 13 illustrent les résultats obtenus pour quelques exemples de données batterie en charge et en décharge pour une température de 25°C et pour une batterie de 60 Ampères heure.

Ces mêmes caractéristiques de batterie ont été utilisées pour différentes températures et pour toute une gamme de batteries.

De nombreuses simulations pour différentes températures et états de charge et types de batterie, ont permis de vérifier que le système selon l'invention délivrait des informations correctes et remplissait l'objectif qui était fixé.

En effet, l'erreur commise entre la détermination à partir du modèle et la mesure, reste inférieure à 50 mV quels que soient le type de batterie, l'état de charge initial et la température de celle-ci.

Ces figures présentent également quelques comparaisons entre la tension obtenue en simulation et la tension mesurée sur la batterie, la batterie considérée ayant une capacité de 60 Ampères heure, à une température de 25°C.

Ces résultats montrent donc la précision de la détermination grâce au système selon l'invention.

**Revendications**

1. Système de détermination de l'état de charge et de la tension d'une batterie de stockage d'énergie électrique, notamment pour véhicule automobile, comportant:

   des premiers moyens de calcul (2) d'état de charge recevant en entrée, des informations d'état de charge initial, de capacité nominale et de courant dans la batterie, pour déterminer un état de charge final ; et
   - des seconds moyens de calcul (3) de tension recevant en entrée, des informations d'état de charge final, de courant dans la batterie et de température de celle-ci, pour déterminer la tension correspondante, **caractérisé en ce que** les seconds moyens de calcul comprennent :

   - des moyens d'estimation (4) de la tension à vide de la batterie, Evide;
   - des moyens de calcul (5) d'une tension, Rint.Ibat, correspondant à la résistance interne équivalente de la batterie ;
   - des moyens de calcul (6) à partir d'une fonction exponentielle, d'un écart de la tension correctif Delta U; et
   - des moyens de combinaison (7) de ces trois valeurs, Evide, Rint.Ibat, Delta u, pour délivrer la tension de la batterie.

2. Système selon la revendication 1, **caractérisé en ce que** la batterie est une batterie plomb/acide.

**Claims**

1. System for determining the state of charge and the voltage of an electric power storage battery, particularly for a motor vehicle, comprising:

   - first means (2) for computing the state of charge receiving, as an input, information on the initial state of charge, nominal capacity and current in the battery, in order to determine a final state of charge; and
   - second means (3) for computing voltage receiving, as an input, information on the final state of charge, current in the battery and temperature of the latter, in order to determine the corresponding voltage, **characterized in that** the second computing means comprise:

- means (4) for estimating the no-load voltage of the battery, Evide;
- means (5) for computing a voltage, Rint - Ibat, corresponding to the equivalent internal resistance of the battery;
- means (6) for computing, based on an exponential function, a corrective voltage deviation, Delta u; and
- means (7) for combining these three values, Evide, Rint, Ibat, Delta u, in order to deliver the battery voltage.

2. System according to Claim 1, **characterized in that** the battery is a lead - acid battery.

**Patentansprüche**

1. System zur Bestimmung des Ladezustands und der Spannung einer elektrischen Speicherbatterie, insbesondere für ein Kraftfahrzeug, umfassend:

- erste Berechnungsmittel (2) für den Ladezustand, die am Eingang Informationen über den Anfangsladezustand, die Nennkapazität und den Strom in der Batterie empfangen, um einen Endladezustand zu bestimmen; und
- zweite Berechnungsmittel (3) für die Spannung, die am Eingang Informationen über den Endladezustand, den Strom in der Batterie und deren Temperatur empfangen, um die entsprechende Spannung zu bestimmen, **dadurch gekennzeichnet, dass** die zweiten Berechnungsmittel umfassen:

- Schätzmittel (4) für die Leerspannung Evide der Batterie;
- Mittel zur Berechnung (5) einer Spannung Rint*IBbat, die dem äquivalenten Innenwiderstand der Batterie entspricht;
- Mittel zur Berechnung (6) einer korrektiven Spannungsabweichung Delta U ausgehend von einer Exponantialfunktion;
- Mittel zur Kombination (7) dieser drei Werte Evide, Rint*Ibat, Delta U, um die Batteriespannung zu erhalten.

2. System nach Anspruch 1, **dadurch gekennzeichnet, dass** die Batterie eine Blei/Säure-Batterie ist.

*FIG.1*

*FIG.2*

*FIG.3*

Tension en circuit ouvert en fonction du
SOC pour différentes températures

**FIG.4**

Tension de décharge pour différents idech et SOC avec T=25°C

**FIG.5**

Iacc en fonction de Ubat et SOC pour T=25°C

Tension de charge en V

## FIG.6

Ubat en fonction de Isacc et SOC pour T=25°C

Courant d'acceptance de charge en A

## FIG.7

Ubat en charge mesurée (———) et simulée (----)T=25°C

Courant d'acceptance de charge en A

## FIG.8

Erreur faite sur Ubat (en V) pour T=25°C

Courant d'acceptance de charge en A

## FIG.9

Erreur relative faite sur Ubat (en%) pour T=25°C

Courant d'acceptance de charge en A

## FIG.10

Tension mesurée (———) et simulée (-----)T=25°C

SOC 100%
SOC 90%
SOC80% SOC 70%
SOC 60%
SOC 50%
SOC 40%

Courant de décharge en A

## FIG.11

Erreur faite sur la tension (en V) pour T=25°C

**FIG.12**

Erreur relative (en %) pour T=25°C

**FIG.13**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6285163 B